# FASCICULE DE BREVET EUROPEEN

(11) **EP 4 041 930 B1**
(45) Date de publication et mention de la délivrance du brevet: **02.08.2023**
(21) Numéro de dépôt: 20796873.6
(22) Date de dépôt: 08.10.2020
(51) Int. Cl.: C23C 14/02, C23C 14/16, C23C 24/04, C23F 1/26, C23F 17/00, C25F 3/08

(54) **PIECE D'AERONEF EN SUPERALLIAGE COMPRENANT DU RHENIUM ET/OU DU RUTHENIUM ET PROCEDE DE FABRICATION ASSOCIE**
LUFTFAHRTTEIL AUS RHENIUM- UND/ODER RUTHENIUMHALTIGER SUPERLEGIERUNG UND ZUGEHÖRIGES HERSTELLUNGSVERFAHREN
AIRCRAFT PART MADE OF SUPERALLOY COMPRISING RHENIUM AND/OR RUTHENIUM AND ASSOCIATED MANUFACTURING METHOD

(30) Priorité: 08.10.2019 FR 1911122
(43) Date de publication de la demande: 17.08.2022
(73) Titulaire: SAFRAN, 75015 Paris (FR)
(72) Inventeur: SABOUNDJI, Amar, 77550 MOISSY-CRAMAYEL (FR); CRABOS, Fabrice, 77550 MOISSY-CRAMAYEL (FR)
(74) Mandataire: Regimbeau
(86) Numéro de dépôt international: PCT/FR2020/051775
(87) Numéro de publication internationale: WO 2021/069842

(56) Documents cités:
- EP-A1- 0 821 076
- EP-A1- 1 184 656
- EP-A2- 2 377 683
- WO-A1-2015/181549
- NAUMENKO D ET AL: "Overview on Recent Developments of Bondcoats for Plasma-Sprayed Thermal Barrier Coatings", JOURNAL OF THERMAL SPRAY TECHNOLOGY, ASM INTERNATIONAL, MATERIALS PARK, US, vol. 26, no. 8, 30 octobre 2017 (2017-10-30), pages 1743-1757, XP036384738, ISSN: 1059-9630, DOI: 10.1007/S11666-017-0649-Z [extrait le 2017-10-30]
- YAO HONGRUI ET AL: "Low inter-diffusivity [gamma]'-base bondcoats for single crystal superalloy René N5. I: Primary study of microstructures and oxidation behaviors at 1100 oC", CORROSION SCIENCE, vol. 147, 26 novembre 2018 (2018-11-26), pages 299-312, XP085569990, ISSN: 0010-938X, DOI: 10.1016/J.CORSCI.2018.11.021

## Description

### DOMAINE DE L'INVENTION

L'invention concerne une pièce d'aéronef, telle qu'une aube de turbine ou une ailette de distributeur par exemple.

### ETAT DE LA TECHNIQUE

Dans un turboréacteur, les gaz d'échappement générés par la chambre de combustion peuvent atteindre des températures élevées, par exemple supérieure à 1200°C, voire 1600°C. Les pièces du turboréacteur, en contact avec ces gaz d'échappement, telles que les aubes de turbine par exemple, doivent ainsi être capables de conserver leurs propriétés mécaniques à ces températures élevées.

A cet effet, il est connu de fabriquer certaines pièces du turboréacteur en « superalliage ». Les superalliages constituent une famille d'alliages métalliques à haute résistance pouvant travailler à des températures relativement proches de leurs points de fusion (typiquement 0,7 à 0,8 fois leurs températures de fusion).

Il est connu d'introduire du rhénium et/ou du ruthénium dans un superalliage pour augmenter sa capacité de résistance mécanique, en particulier au fluage, à haute température. En particulier, l'introduction de rhénium et/ou de ruthénium permet d'augmenter la température d'utilisation de ces superalliages d'environ 100°C par rapport aux superalliages dénués de rhénium et/ou de ruthénium.

Toutefois, l'augmentation de la fraction massique moyenne de rhénium et/ou de ruthénium du superalliage nécessite une réduction de la fraction massique moyenne de chrome du superalliage, de manière garder une structure allotropique stable du superalliage, en particulier une phase γ-γ' stable. Or, le chrome dans le superalliage favorise la formation d'oxyde Cr₂O₃, ayant la même structure cristallographique que α-Al₂O₃ et ainsi permettant la germination d'une couche de α-Al₂O₃. Cette couche de α-Al₂O₃ stable contribue à protéger le superalliage contre l'oxydation. L'augmentation de la fraction massique moyenne de rhénium et/ou de ruthénium entraîne par conséquent une résistance moindre à l'oxydation du superalliage comparativement à un superalliage dépourvu de rhénium et/ou de ruthénium.

Afin de renforcer la résistance thermique de ces superalliages et de les protéger contre l'oxydation et la corrosion, il est également connu de les recouvrir d'une barrière thermique.

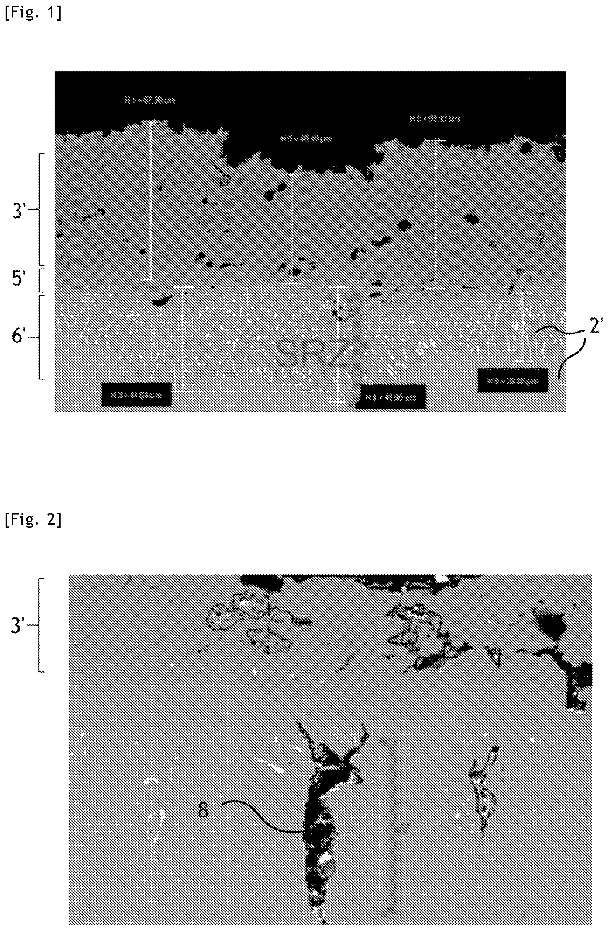

En référence à la figure 1 et 2, une pièce 1 d'aéronef de l'art antérieur peut par exemple comprendre un substrat 2' en superalliage métallique monocristallin recouvert d'un revêtement, par exemple d'une barrière environnementale comprenant une barrière thermique.

La barrière environnementale comprend typiquement un revêtement de protection 3' entre le substrat 2' et la barrière thermique Le revêtement de protection 3' est préférentiellement une couche de liaison 3' métallique. La couche de liaison 3' recouvre le substrat 2' en superalliage métallique. La couche de liaison 3' est elle-même typiquement recouverte par une couche protectrice, formée par oxydation de la couche de liaison 3' métallique. La couche protectrice permet de protéger le substrat 2' en superalliage de la corrosion et/ou de l'oxydation. La barrière thermique recouvre la couche protectrice. La barrière thermique peut être en céramique, par exemple en zircone yttriée.

La fraction massique moyenne en aluminium de la sous-couche 3' est suffisante pour former exclusivement une couche protectrice d'oxyde d'aluminium (Al₂O₃) permettant de protéger le substrat 2' en superalliage contre l'oxydation et la corrosion.

Toutefois, lorsque la pièce est soumise à de hautes températures, la différence des fraction massiques moyennes en nickel, et surtout en aluminium, entre le substrat 2' en superalliage et la couche de liaison 3' métallique entraîne une diffusion des différents éléments, en particulier du nickel compris dans le substrat vers la couche de liaison métallique, et de l'aluminium compris dans la couche de liaison métallique vers le superalliage. Ce phénomène est appelé « inter-diffusion ».

L'inter-diffusion peut entraîner la formation de zones de réaction primaires et secondaires (appelée « SRZ » ou *Secondary Reaction Zone* en anglais) dans une partie du substrat 2' en contact avec la couche de liaison 3'. Ces zones sont communément appelées « zones d'interdiffusion ».

La figure 1 est une microphotographie de la section d'une couche de liaison 3' recouvrant un substrat 2' d'une pièce 1' de l'art antérieur. La microphotographie est réalisée après que la pièce a été soumise à une série de cycles thermiques permettant de simuler les conditions en température de la pièce 1' lors de son utilisation. Le substrat 2' est riche en rhénium, c'est-à-dire que la fraction massique moyenne en rhénium est supérieure ou égale à 3 % et préférentiellement à 4 %. Il est connu d'utiliser le rhénium dans la composition des superalliages pour augmenter la résistance au fluage des pièces en superalliage. Typiquement, le substrat 2' présente une phase γ-γ', et en particulier une phase γ-Ni. Le substrat 2' présente une zone d'inter-diffusion primaire 5', dans la partie du substrat directement recouverte par la couche de liaison 3'. Le substrat 2' présente également une zone d'inter-diffusion secondaire 6', directement recouverte par la zone d'inter-diffusion primaire 5'.

En référence à la figure 2, les phénomènes d'inter-diffusion entraînent un appauvrissement prématuré de la couche de liaison 3' en aluminium, ce qui favorise des transformations de phases dans la couche de liaison 3' (par exemple des transformations martensitique). Ces transformations modifient la structure allotropique de la couche de liaison 3' et/ou des zones d'inter-diffusion, et y génèrent des fissures 8 après des sollicitations thermomécaniques de type fluage, favorisant la dégradation prématurée par fluage du système comprenant le superalliage et le revêtement.

Ainsi, les inter-diffusions entre le substrat 2' en superalliage et la couche de liaison 3' peuvent avoir des conséquences néfastes sur la durée de vie de la pièce en superalliage.

Pour éviter ces phénomènes, il est connu du document EP 2 377 683 A2 de déposer sur le substrat 2' une couche de liaison 3' présentant une phase γ-γ' et une fraction massique moyenne en rhénium égale à 1,3%, soit par pulvérisation plasma à basse pression, soit par évaporation à arc cathodique.

### EXPOSE DE L'INVENTION

Un but de l'invention est de proposer une solution pour protéger efficacement une pièce de turbine en superalliage de l'oxydation et de la corrosion tout en augmentant sa durée de vie, lors de son utilisation, par rapport aux pièces connues.

Un autre but de l'invention est de limiter ou d'empêcher la formation de zones de réaction secondaires tout en permettant à un oxyde l'aluminium d'être formé lors de l'utilisation de la pièce.

Enfin, un autre but de l'invention est d'empêcher au moins partiellement la formation de fissures dans le substrat d'une pièce soumise à des conditions de températures élevées, par exemple supérieures à 1000°C ainsi que l'écaillage de la couche protectrice en oxyde d'aluminium.

Ces buts sont atteints dans le cadre de la présente invention grâce à un procédé de fabrication d'une pièce, comprenant les étapes de :
a) attaque chimique en milieu humide acide d'au moins une partie d'une surface d'un substrat en superalliage monocristallin, comprenant au moins un élément choisi parmi le rhénium et le ruthénium, le substrat présentant une phase γ-γ', le substrat présentant une fraction massique moyenne en rhénium et/ou en ruthénium supérieure ou égale à 3 %, préférentiellement supérieure ou égale à 4 %, l'attaque chimique étant mise en oeuvre de sorte que la fraction massique moyenne en rhénium et/ou en ruthénium sur la partie de la surface du substrat soit inférieure à 2 %,
b) dépôt sur la partie du substrat d'un revêtement de protection présentant une phase γ-γ' et une fraction massique moyenne en rhénium et/ou en ruthénium inférieure à 1 %.

L'invention est avantageusement complétée par les caractéristiques suivantes, prises individuellement ou en l'une quelconque de leurs combinaisons techniquement possibles :
- le substrat est en superalliage monocristallin base nickel,
- le substrat comprend du chrome, la fraction massique moyenne en chrome étant inférieure à 5 % et préférentiellement inférieure à 3 %,
- l'attaque chimique est une gravure chimique,
- l'attaque chimique est mise en oeuvre de sorte à ce que la partie de la surface du substrat présente une rugosité moyenne arithmétique Rₐ comprise entre 0,5 µm et 5 µm et préférentiellement une rugosité maximale R_{z} comprise entre 5,5 µm et 50 µm, les rugosités Rₐ et R_{z} étant mesurées sur des surfaces supérieures à 1mm²,
- l'attaque chimique en milieu acide est mise en oeuvre par un bain en contact avec la partie de la surface du substrat, le bain comprenant au moins un élément parmi de l'acide fluorhydrique, de l'acide nitrique avec du chlorure ferrique et avec de l'acide chlorhydrique, de l'acide chlorhydrique avec du chlorure ferrique, de l'acide chlorhydrique avec de l'eau oxygénée, et de l'acide nitrique avec de l'acide chlorhydrique,
- l'attaque chimique en milieu acide est mise en oeuvre par un bain en contact avec la partie de la surface du substrat, un potentiel électrique du bain étant contrôlé de sorte à entraîner une réaction électrochimique sur la partie de la surface, le bain comprenant préférentiellement au moins un élément parmi de l'acide nitrique et de l'acide acétique, de l'acide sulfurique, et de l'acide phosphorique.

Un autre aspect de l'invention est une pièce, comprenant :
- un substrat en superalliage monocristallin, comprenant au moins un élément choisi parmi le rhénium et le ruthénium, le substrat présentant une phase γ-γ', une fraction massique moyenne en rhénium et/ou en ruthénium supérieure ou égale à 3 %, préférentiellement supérieure ou égale à 4 %,
- un revêtement de protection recouvrant au moins une partie d'une surface du substrat,
- la fraction massique moyenne en rhénium et/ou en ruthénium sur la partie de la surface du substrat étant inférieure à 2 %, et
- le revêtement de protection présentant une phase γ-γ' et une fraction massique moyenne en rhénium et/ou en ruthénium inférieure à 1 %.

L'invention est avantageusement complétée par les caractéristiques suivantes, prises individuellement ou en l'une quelconque de leurs combinaisons techniquement possibles :
- le substrat comprend du chrome, la fraction massique moyenne en chrome étant inférieure à 5 % et préférentiellement inférieure à 3 %,
- la partie de surface du substrat présente une rugosité moyenne arithmétique Rₐ comprise entre 0,5 µm et 5 µm et préférentiellement une rugosité maximale R_{z} comprise entre 5,5 µm et 50 µm, les rugosités Rₐ et R_{z} étant mesurées sur des surfaces supérieures à 1 mm² et étant obtenues par attaque chimique en milieu humide acide de la partie de surface du substrat,
- le revêtement de protection présente majoritairement en volume une phase γ',
- le revêtement de protection comprend au moins du nickel, de l'aluminium, du chrome, du hafnium et du silicium,
- le revêtement de protection présente :
- une fraction massique moyenne en nickel majoritaire,
- une fraction massique moyenne en aluminium comprise entre 5 % et 15 %,
- une fraction massique moyenne en chrome comprise entre 7 % et 15 %,
- une fraction massique moyenne en hafnium comprise entre 0,5 % et 2 %, et
- une fraction massique moyenne en silicium comprise entre 0,5 % et 3 %.

Un autre aspect de l'invention est une pièce d'aéronef conforme à l'invention.

Un autre aspect de l'invention est une turbine d'aéronef comprenant une pièce conforme à l'invention.

Un autre aspect de l'invention est un aéronef comprenant une pièce conforme à l'invention.

### DESCRIPTION DES FIGURES

D'autres caractéristiques, buts et avantages de l'invention ressortiront de la description qui suit, qui est purement illustrative et non limitative, et qui doit être lue en regard des dessins annexés sur lesquels :
[Fig. 1] - la figure 1, déjà commentée, est une photographie en microscopie électronique à balayage de la microstructure d'un substrat et d'une couche de liaison de l'art antérieur, après que la pièce a subi un travail thermique représentatif de l'utilisation de la pièce,
[Fig. 2] - la figure 2, déjà commentée, est une photographie en microscopie électronique à balayage de la microstructure d'un détail d'un substrat et d'une couche de liaison de l'art antérieur, après que la pièce a subi une sollicitation thermomécanique représentative de l'utilisation de la pièce, le substrat comprenant une fissure,
[Fig. 3] - la figure 3 illustre schématiquement une section d'une pièce d'aéronef, par exemple une aube de turbine ou une ailette de distributeur.
[Fig. 4] - la figure 4 illustre schématiquement un procédé de fabrication d'une pièce selon un mode de réalisation de l'invention,

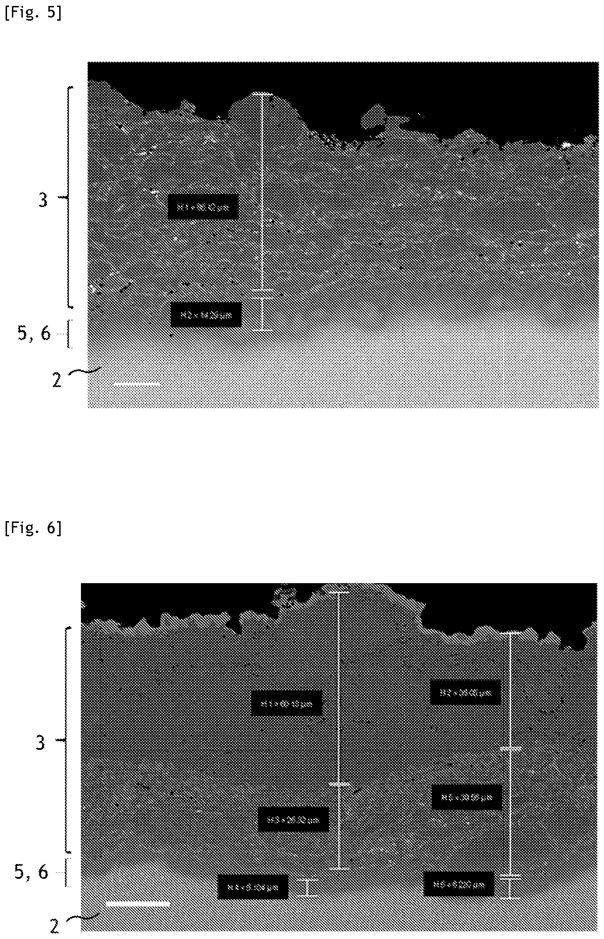

[Fig. 5] - la figure 5 est une photographie en microscopie électronique à balayage de la microstructure d'un substrat et d'une couche de liaison selon un mode de réalisation de l'invention,
[Fig. 6] - la figure 6 est une photographie en microscopie électronique à balayage de la microstructure d'un substrat et d'une couche de liaison selon un mode de réalisation de l'invention,

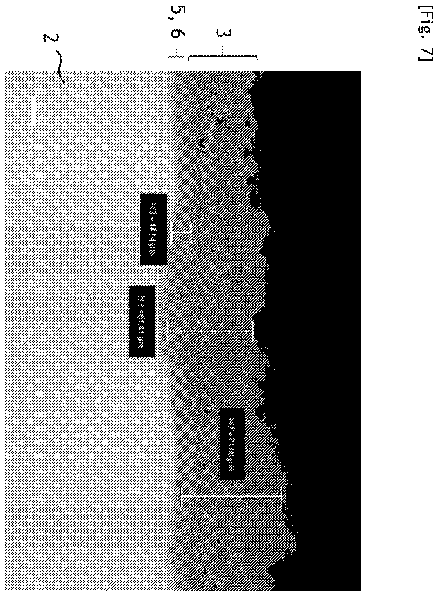

[Fig. 7] - la figure 7 est une photographie en microscopie électronique à balayage de la microstructure d'un substrat et d'une couche de liaison selon un mode de réalisation de l'invention,

Sur l'ensemble des figures, les éléments similaires portent des références identiques.

### DEFINITIONS

On désigne par le terme « superalliage » un alliage présentant, à haute température et à haute pression, une très bonne résistance à l'oxydation, à la corrosion, au fluage et à des contraintes cycliques (notamment mécaniques ou thermiques). Les superalliages trouvent une application particulière dans la fabrication de pièces utilisées dans l'aéronautique, par exemple des aubes de turbine, car ils constituent une famille d'alliages à haute résistance pouvant travailler à des températures relativement proches de leurs points de fusion (typiquement 0,7 à 0,8 fois leurs températures de fusion).

Un superalliage peut présenter une microstructure biphasique comprenant une première phase (appelée « phase γ ») formant une matrice, et une deuxième phase (appelée « phase γ' ») formant des précipités durcissant dans la matrice. La coexistence de ces deux phases est désignée par « phase γ- γ' ».

La « base » du superalliage désigne le composant métallique principal de la matrice. Dans la majorité des cas, les superalliages comprennent une base fer, cobalt, ou nickel, mais également parfois une base titane ou aluminium. La base du superalliage est préférentiellement une base nickel.

Les « superalliages base nickel » présentent l'avantage d'offrir un bon compromis entre résistance à l'oxydation, résistance à la rupture à haute température et poids, ce qui justifie leur emploi dans les parties les plus chaudes des turboréacteurs.

Les superalliages base nickel sont constitués d'une phase γ (ou matrice) de type austénitique cubique à face centrée γ-Ni, contenant éventuellement des additifs en solution solide de substitution α (Co, Cr, W, Mo), et d'une phase γ' (ou précipités) de type γ'-Ni₃X, avec X = Al, Ti ou Ta. La phase γ' possède une structure L12 ordonnée, dérivée de la structure cubique à face centrée, cohérente avec la matrice, c'est-à-dire ayant une maille atomique très proche de celle-ci.

De par son caractère ordonné, la phase γ' présente la propriété remarquable d'avoir une résistance mécanique qui augmente avec la température jusqu'à 800°C environ. La cohérence très forte entre les phases γ et γ' confère une tenue mécanique à chaud très élevée des superalliages à base nickel, qui dépend elle-même du ratio γ/γ' et de la taille des précipités durcissant.

Un superalliage est, dans l'ensemble des modes de réalisation de l'invention, riche en rhénium et ou en ruthénium, c'est-à-dire que la fraction massique moyenne en rhénium et en ruthénium du superalliage est supérieure ou égale à 3 %, et préférentiellement à 4 %, permettant d'augmenter la résistance au fluage des pièces en superalliage comparativement aux pièces en superalliage sans rhénium.

Un superalliage est préférentiellement pauvre en chrome en moyenne, c'est-à-dire que la fraction massique moyenne dans l'ensemble du superalliage en chrome est inférieure à 5 %, préférentiellement inférieure à 3 %. En effet, l'appauvrissement en chrome lors d'un enrichissement en rhénium et/ou en ruthénium du superalliage permet de manière garder une structure allotropique stable du superalliage, en particulier une phase γ-γ'.

Les termes « fraction massique » désignent le rapport de la masse d'un élément ou d'un groupe d'éléments sur la masse totale.

Des aspects de la rugosité d'une surface peuvent être définis préférentiellement par la rugosité moyenne arithmétique, appelée Rₐ mesurée sur une surface supérieure à 1 mm², et/ou par la rugosité maximale, appelée R_{z} mesurée sur une surface supérieure à 1 mm². La ou les mesures de rugosité peuvent être par mises en oeuvre par un profilomètre optique ou mécanique.

On entend par « attaque chimique en milieu humide acide » d'une surface d'un substrat la mise en contact, par exemple sous forme d'un bain, de la surface du substrat avec une phase liquide comprenant un acide. La phase liquide peut être aqueuse, présentant une concentration prédéterminée d'acide. En variante, la phase liquide peut comprendre un acide pur sous forme liquide. Une attaque chimique peut, en particulier, être une attaque électrochimique.

On entend par « revêtement de protection » une couche recouvrant le substrat et permettant de le protéger chimiquement et/ou mécaniquement. Le revêtement de protection permet préférentiellement d'éviter la corrosion et/ou l'oxydation du substrat. Le revêtement de protection peut être préférentiellement une couche de liaison entre le substrat et une couche de protection thermique.

### DESCRIPTION DETAILLEE DE L'INVENTION

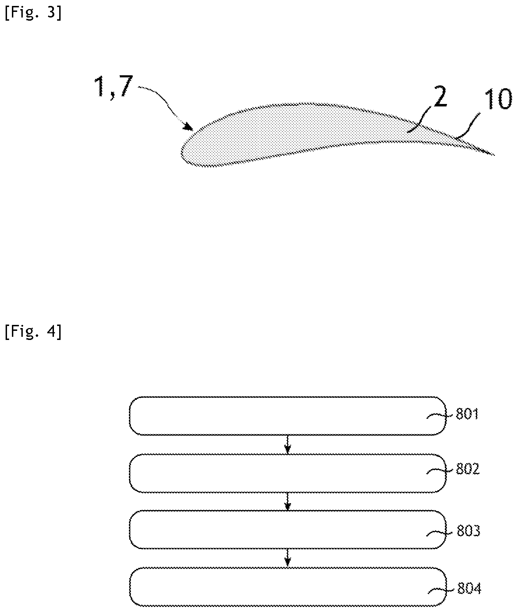

En référence à la figure 3, une pièce 1, préférentiellement une pièce 1 d'aéronef, comprend un substrat 2 en superalliage monocristallin. Le superalliage monocristallin est préférentiellement un superalliage base nickel, mais peut être également un superalliage base cobalt, par exemple obtenu par un procédé de coulée equiaxe ou par solidification dirigée. Le substrat 2 comprend du chrome et au moins un élément choisi parmi le rhénium et le ruthénium. Le substrat 2 présente une phase γ-γ', et une fraction massique moyenne en rhénium et/ou en ruthénium supérieure ou égale à 3 %, et préférentiellement à 4 %. Préférentiellement, le substrat 2 comprend une fraction massique moyenne en chrome inférieure ou égale à 5 % et préférentiellement inférieure ou égale à 3 %. Le substrat 2 peut être par exemple fabriqué en CMSX4 plus (marque déposée), présentant la composition chimique, en pourcentage de fraction massique moyenne, décrite dans le tableau 1.

**[Tableaux 1]**

| Cr | Co | Mo | Ta | W | Cb | Re | Al | Ti | Hf | Ni |
|---|---|---|---|---|---|---|---|---|---|---|
| 3,5 | 10 | 0,6 | 8 | 6 | 0 | 4,8 | 5,7 | 0,85 | 0,1 | Reste |

La pièce 1 comprend également un revêtement de protection 3. Le revêtement de protection 3 recouvre au moins une partie de la surface du substrat 2. Le revêtement de protection 3 présente majoritairement en volume une phase une phase γ-γ'. Ainsi, la structure allotropique du revêtement de protection 3 est similaire à celle du substrat 2, ce qui permet d'éviter ou d'amoindrir la formation d'une couche de réaction secondaire dans le substrat 2 lors de l'utilisation de la pièce 1.

Le revêtement de protection 3 peut être formée par dépôt physique ou chimique. Elle peut préférentiellement être formée sous vide, en phase vapeur (procédé de PVD, acronyme du terme anglais « *Physical Vapor Déposition* »). Différentes méthodes de PVD peuvent être utilisées pour la fabrication de la couche d'enrichissement 11, telles que la pulvérisation cathodique, l'évaporation par canon à électron, l'ablation laser et le dépôt physique en phase vapeur assisté par faisceau d'électrons. Le revêtement de protection 3 peut, en variante, être formée par projection thermique, et plus particulièrement par projection thermique haute vitesse à oxygène (ou en anglais « *High velocity oxygen fuel spraying* », d'acronyme *« HVOF »).*

Le revêtement de protection 3 présente une fraction massique moyenne en rhénium et/ou en ruthénium inférieure à 1 %, et préférentiellement ne comprend pas de rhénium ou de ruthénium. Ainsi, il est possible d'éviter la formation d'une zone secondaire de réaction dans le substrat 2. Le revêtement de protection 3 est préférentiellement fabriquée en matériau de type, MCrAlY, ou M représente au moins un élément choisi parmi Ni, Co et Fe.

En variante, le revêtement de protection 3 est fabriquée en matériau de type NiAlCrHfSi, c'est-à-dire que le revêtement de protection 3 comprend au moins du nickel, de l'aluminium, du chrome, du hafnium et du silicium. Notamment, le revêtement de protection 3 présente une fraction massique moyenne en nickel majoritaire, une fraction massique moyenne en aluminium comprise entre 5 % et 15 %, une fraction massique moyenne en chrome comprise entre 7 % et 15 %, une fraction massique moyenne en Hafnium comprise entre 0,5 % et 2 %, et une fraction massique moyenne en silicium comprise entre 0,5 % et 3 %. Ainsi, la structure allotropique du revêtement de protection 3 est stable, et peut rester de type γ-γ' pendant l'utilisation de la pièce 1. Les transformations de type martensitique peuvent être ainsi évitées. En particulier, le revêtement de protection 3 peut présenter une base nickel, une fraction massique moyenne en aluminium d'environ 6 % une fraction massique moyenne en chrome d'environ 12 %, une fraction massique moyenne en hafnium d'environ 1,7 % et une fraction massique moyenne en silicium d'environ 0,3 %.

Les inventeurs ont découvert que la stabilité du revêtement de protection 3, lors de l'utilisation de la pièce 1, peut être accrue en diminuant l'écart de fraction massique moyenne en rhénium et/ou en ruthénium entre le substrat 2 et le revêtement de protection 3. Ainsi, le substrat 2 présente une fraction massique moyenne en surface en rhénium et/ou en ruthénium, ou plus particulièrement sur la partie de la surface du substrat 2 destinée à être en contact avec le revêtement de protection 3, inférieure à 2 %, et préférentiellement inférieure à 1 %.

De manière connue, l'état de surface du substrat 2 peut être contrôlé par sablage avant la formation du revêtement de protection 3 sur le substrat 2. Les inventeurs ont découvert que la rugosité entraînée par le sablage était trop élevée pour assurer une adhésion tolérable entre le substrat 2 et le revêtement de protection 3 lors de l'utilisation de la pièce 1. La partie de surface du substrat 2 présente une rugosité moyenne arithmétique Rₐ comprise entre 0,5 µm et 5 µm et préférentiellement une rugosité maximale R_{z} comprise entre 5,5 µm et 50 µm, les rugosités Rₐ et R_{z} étant mesurées sur des surfaces supérieures à 1mm². Les rugosité Rₐ et R_{z} sont obtenue par l'attaque chimique en milieu humide acide de la partie de surface du substrat 2. L'attaque chimique peut être mise en oeuvre en complément du sablage de la partie de la surface du substrat. Ces gammes de rugosité permettent de réduire les contraintes mécaniques à la surface du substrat 2 quand le revêtement de protection 3 est déposée, et ainsi permet d'améliorer l'adhésion entre le substrat 2 et le revêtement de protection 3.

En référence à la figure 4, un procédé de fabrication d'une pièce 1 peut comprendre une étape 801 de fourniture d'un substrat 2 en superalliage monocristallin, préférentiellement base nickel, comprenant du chrome et au moins un élément choisi parmi le rhénium et le ruthénium, le substrat 2 présentant une fraction massique moyenne en rhénium et/ou en ruthénium supérieure ou égale à 3 %, et préférentiellement à 4 %, et une fraction massique moyenne en chrome inférieure ou égale à 5 % et préférentiellement inférieure ou égale à 3 %.

Le procédé peut comprendre une étape 802 de contrôle mécanique de l'état de surface du substrat 2, préférentiellement une étape de sablage de la surface.

Le procédé comprend une étape 803 d'attaque chimique en milieu humide acide d'au moins une partie de la surface d'un substrat 2, et préférentiellement une étape de gravure chimique en milieu humide acide. Les inventeurs ont découvert que l'attaque chimique en milieu humide acide de la surface du substrat permet, d'une part, de diminuer la fraction massique moyenne en rhénium et/ou en ruthénium à la surface du substrat 2, et/ou permet, d'autre part, de contrôler la rugosité de la surface du substrat 2 dans les gammes de rugosités Rₐ et R_{z} précitées. La fraction massique moyenne en rhénium et/ou en ruthénium peut préférentiellement être inférieure, en moyenne, à 2 % dans une couche de la partie du substrat 2 allant de la surface du substrat 2 jusqu'à 10 µm de la surface du substrat 2 en profondeur.

L'attaque chimique en milieu humide peut être mise en oeuvre en baignant la partie de la surface du substrat 2 dans au moins un élément parmi de l'acide fluorhydrique, de l'acide nitrique avec du chlorure ferrique et de l'acide chlorhydrique, de l'acide chlorhydrique avec du chlorure ferrique, de l'acide chlorhydrique avec de l'eau oxygénée, de l'acide nitrique avec de l'acide chlorhydrique.

En variante ou en combinaison, l'attaque chimique en milieu acide peut être mise en oeuvre en contrôlant le potentiel d'un bain en contact avec la partie de la surface du substrat 2 de sorte à entraîner une réaction électrochimique. Le bain comprend préférentiellement au moins un élément parmi de l'acide nitrique et de l'acide acétique, de l'acide sulfurique, et de l'acide phosphorique.

### Exemples d'attaques chimiques

### Exemple 1

L'attaque chimique du substrat 2 peut comprendre un bain du substrat 2 dans un mélange d'acide chlorhydrique et de chlorure ferrique. Le volume d'acide chlorhydrique peut être compris entre 7 % et 15 % du volume de chlorure ferrique. Le bain est agité à l'air comprimé. Le bain est maintenu à une température de 65°C pendant un temps compris entre 250 s et 3000 s. Le bain est ensuite rincé de la surface du substrat 2 par de l'eau froide pendant 5 min. La surface du substrat 2 est ensuite neutralisée par une solution de soude présentant une concentration massique de 300 g/L, pendant 5 min, à une température de 75°C. La solution de neutralisation est agitée à l'air comprimé. La solution de neutralisation est ensuite rincée de la surface du substrat 2 par de l'eau froide pendant 5 min. La surface du substrat 2 est rincée une nouvelle fois par de l'eau froide pendant 5 min dans un bain à ultrasons. La surface du substrat 2 est séchée après un rinçage de la surface par de l'eau à 80°C pendant 5 min.

### Exemple 2

Le substrat 2 est rincé à l'eau pendant 1 à 2 minutes à température ambiante. L'attaque chimique comprend un bain du substrat 2 dans une solution composée de H₃PO₄ (70 % en volume) et d'eau (30 % en volume). Le bain est maintenu à une température comprise entre 30 à 70°C pendant un temps compris entre 180 s et 3000 s. Un courant électrique compris entre 2 et 10 A est appliqué sur le substrat, correspondant à un courant surfacique compris entre 0,2 et 2 A.cm². Le bain est ensuite rincé de la surface du substrat 2 par de l'eau froide pendant 5 min. La surface du substrat 2 est ensuite neutralisée par une solution de soude présentant une concentration massique de 300 g/L, pendant 5 min, à une température comprise entre 50°C et 80°C. La solution de neutralisation est agitée à l'air comprimé. La solution de neutralisation est ensuite rincée de la surface du substrat 2 par de l'eau froide pendant 5 min. La surface du substrat 2 est rincée une nouvelle fois par de l'eau froide pendant 5 min dans un bain à ultrasons. La surface du substrat 2 est séchée après un rinçage de la surface par de l'eau à 80°C pendant 5 min.

Le procédé comprend, après l'étape 803 d'attaque chimique, une étape 804 de dépôt du revêtement de protection 3, préférentiellement selon l'une des méthodes précitées.

## Revendications

1. Procédé de fabrication d'une pièce (1), comprenant les étapes de :
a) attaque chimique en milieu humide acide d'au moins une partie d'une surface d'un substrat (2) en superalliage monocristallin, comprenant au moins un élément choisi parmi le rhénium et le ruthénium, le substrat (2) présentant une phase γ-γ', le substrat (2) présentant une fraction massique moyenne en rhénium et/ou en ruthénium supérieure ou égale à 3 %, préférentiellement supérieure ou égale à 4 %, l'attaque chimique étant mise en oeuvre de sorte que la fraction massique moyenne en rhénium et/ou en ruthénium sur la partie de la surface du substrat (2) soit inférieure à 2 %,
b) dépôt sur la partie du substrat (2) d'un revêtement de protection (3) présentant une phase γ-γ' et une fraction massique moyenne en rhénium et/ou en ruthénium inférieure à 1 %.

2. Procédé selon la revendication 1, dans lequel le substrat (2) est en superalliage monocristallin base nickel.

3. Procédé selon la revendication 1 ou 2, dans lequel le substrat (2) comprend du chrome, la fraction massique moyenne en chrome étant inférieure à 5 % et préférentiellement inférieure à 3 %.

4. Procédé selon l'une des revendications 1 à 3, dans lequel l'attaque chimique est une gravure chimique.

5. Procédé selon l'une des revendications 1 à 4, dans lequel l'attaque chimique est mise en oeuvre de sorte à ce que la partie de la surface du substrat (2) présente une rugosité moyenne arithmétique Rₐ comprise entre 0,5 µm et 5 µm et préférentiellement une rugosité maximale R_{z} comprise entre 5,5 µm et 50 µm, les rugosités Rₐ et R_{z} étant mesurées sur des surfaces supérieures à 1mm².

6. Procédé selon l'une des revendications 1 à 5, dans lequel l'attaque chimique en milieu acide est mise en oeuvre par un bain en contact avec la partie de la surface du substrat (2), le bain comprenant au moins un élément parmi de l'acide fluorhydrique, de l'acide nitrique avec du chlorure ferrique et avec de l'acide chlorhydrique, de l'acide chlorhydrique avec du chlorure ferrique, de l'acide chlorhydrique avec de l'eau oxygénée, et de l'acide nitrique avec de l'acide chlorhydrique.

7. Procédé selon l'une de revendications 1 à 6, dans lequel l'attaque chimique en milieu acide est mise en oeuvre par un bain en contact avec la partie de la surface du substrat (2), un potentiel électrique du bain étant contrôlé de sorte à entraîner une réaction électrochimique sur la partie de la surface, le bain comprenant préférentiellement au moins un élément parmi de l'acide nitrique et de l'acide acétique, de l'acide sulfurique, et de l'acide phosphorique.

8. Pièce (1), comprenant :
- un substrat (2) en superalliage monocristallin, comprenant au moins un élément choisi parmi le rhénium et le ruthénium, le substrat (2) présentant une phase γ-γ', une fraction massique moyenne en rhénium et/ou en ruthénium supérieure ou égale à 3 %, préférentiellement supérieure ou égale à 4 %,
- un revêtement de protection (3) recouvrant au moins une partie d'une surface du substrat (2),
**caractérisée en ce que**
- la fraction massique moyenne en rhénium et/ou en ruthénium sur la partie de la surface du substrat (2) est inférieure à 2 %, et
- le revêtement de protection (3) présente une phase γ-γ' et une fraction massique moyenne en rhénium et/ou en ruthénium inférieure à 1 %.

9. Pièce (1) selon la revendication 8, dans laquelle le substrat (2) comprend du chrome, la fraction massique moyenne en chrome étant inférieure à 5 % et préférentiellement inférieure à 3 %.

10. Pièce (1) selon la revendication 8 ou 9, dans laquelle la partie de surface du substrat (2) présente une rugosité moyenne arithmétique Rₐ comprise entre 0,5 µm et 5 µm et préférentiellement une rugosité maximale R_{z} comprise entre 5,5 µm et 50 µm, les rugosités Rₐ et R_{z} étant mesurées sur des surfaces supérieures à 1 mm² et étant obtenues par attaque chimique en milieu humide acide de la partie de surface du substrat (2).

11. Pièce (1) selon l'une des revendications 8 à 10, dans laquelle le revêtement de protection (3) présente majoritairement en volume une phase γ'.

12. Pièce (1) selon l'une des revendications 8 à 11, dans laquelle le revêtement de protection (3) comprend au moins du nickel, de l'aluminium, du chrome, du hafnium et du silicium.

13. Pièce (1) selon la revendication 12, dans laquelle le revêtement de protection (3) présente :
- une fraction massique moyenne en nickel majoritaire,
- une fraction massique moyenne en aluminium comprise entre 5 % et 15 %,
- une fraction massique moyenne en chrome comprise entre 7 % et 15 %,
- une fraction massique moyenne en hafnium comprise entre 0,5 % et 2 %, et
- une fraction massique moyenne en silicium comprise entre 0,5 % et 3 %.

14. Pièce d'aéronef conforme à l'une des revendications 8 à 13.

15. Turbine d'aéronef comprenant une pièce conforme à l'une des revendications 8 à 14.

16. Aéronef comprenant une pièce conforme à l'une des revendications 8 à 14.

## Patentansprüche

1. Verfahren zur Herstellung eines Teils (1), umfassend die folgenden Schritte:
a) chemisches Angreifen in saurem feuchtem Medium mindestens eines Abschnitts einer Oberfläche eines Substrats (2) aus monokristalliner Superlegierung, umfassend mindestens ein Element, das aus Rhenium und Ruthenium ausgewählt ist, wobei das Substrat (2) eine Phase γ-γ' aufweist, wobei das Substrat (2) einen mittleren Massenanteil an Rhenium und/oder an Ruthenium von über oder gleich 3%, vorzugsweise von über oder gleich 4% aufweist, wobei das chemische Angreifen derart durchgeführt wird, dass der mittlere Massenanteil an Rhenium und/oder an Ruthenium auf dem Abschnitt der Oberfläche des Substrats (2) kleiner als 2% ist,
b) Aufbringen einer Schutzbeschichtung (3), die eine Phase γ-γ' und einen mittleren Massenanteil an Rhenium und/oder an Ruthenium von unter 1% aufweist, auf den Abschnitt des Substrats (2).

2. Verfahren nach Anspruch 1, wobei das Substrat (2) aus nickelbasierter monokristalliner Superlegierung ist.

3. Verfahren nach Anspruch 1 oder 2, wobei das Substrat (2) Chrom umfasst, wobei der mittlere Massenanteil an Chrom kleiner als 5% und vorzugsweise kleiner als 3% ist.

4. Verfahren nach einem der Ansprüche 1 bis 3, wobei das chemische Angreifen ein chemisches Ätzen ist.

5. Verfahren nach einem der Ansprüche 1 bis 4, wobei das chemische Angreifen derart durchgeführt wird, dass der Abschnitt der Oberfläche des Substrats (2) eine arithmetische Durchschnittsrauigkeit Rₐ aufweist, die zwischen 0,5 µm und 5 µm liegt und vorzugsweise eine maximale Rauigkeit R_{z}, die zwischen 5,5 µm und 50 µm liegt, wobei die Rauigkeiten Rₐ und R_{z} auf Oberflächen größer als 1 mm² gemessen werden.

6. Verfahren nach einem der Ansprüche 1 bis 5, wobei das chemische Angreifen in saurem Medium durch ein Bad im Kontakt mit dem Abschnitt der Oberfläche des Substrats (2) durchgeführt wird, wobei das Bad mindestens einen Bestandteil von der Fluorwasserstoffsäure, der Salpetersäure mit Eisenchlorid und mit Salzsäure, der Salzsäure mit Eisenchlorid, der Salzsäure mit Wasserstoffperoxid und der Salpetersäure mit Salzsäure aufweist.

7. Verfahren nach einem der Ansprüche 1 bis 6, wobei das chemische Angreifen in saurem Medium durch ein Bad im Kontakt mit dem Abschnitt der Oberfläche des Substrats (2) durchgeführt wird, wobei ein elektrisches Potential des Bades derart gesteuert wird, dass eine elektrochemische Reaktion auf dem Abschnitt der Oberfläche hervorgerufen wird, wobei das Bad vorzugsweise mindestens einen Bestandteil von der Salpetersäure und der Essigsäure, der Schwefelsäure und der Phosphorsäure umfasst.

8. Teil (1), umfassend:
- ein Substrat (2) aus monokristalliner Superlegierung, umfassend mindestens ein Element, das aus Rhenium und Ruthenium ausgewählt ist, wobei das Substrat (2) eine Phase γ-γ', einen mittleren Massenanteil an Rhenium und/oder an Ruthenium von über oder gleich 3%, vorzugsweise von über oder gleich 4% aufweist,
- eine Schutzbeschichtung (3), die mindestens einen Abschnitt der Oberfläche des Substrats (2) bedeckt,
**dadurch gekennzeichnet, dass**
- der mittlere Massenanteil an Rhenium und/oder an Ruthenium auf dem Abschnitt der Oberfläche des Substrats (2) kleiner als 2% ist, und
- die Schutzbeschichtung (3) eine Phase γ-γ' und einen mittleren Massenanteil an Rhenium und/oder an Ruthenium von unter 1% aufweist.

9. Teil (1) nach Anspruch 8, wobei das Substrat (2) Chrom umfasst, wobei der mittlere Massenanteil an Chrom kleiner als 5% und vorzugsweise kleiner als 3% ist.

10. Teil (1) nach Anspruch 8 oder 9, wobei der Oberflächenabschnitt des Substrats (2) eine arithmetische Durchschnittsrauigkeit Rₐ aufweist, die zwischen 0,5 µm und 5 µm liegt und vorzugsweise eine maximale Rauigkeit R_{z}, die zwischen 5,5 µm und 50 µm liegt, wobei die Rauigkeiten Rₐ und R_{z} auf Oberflächen größer als 1 mm² gemessen werden und durch chemisches Angreifen in saurem feuchtem Medium des Oberflächenabschnitts des Substrats (2) erhalten werden.

11. Teil (1) nach einem der Ansprüche 8 bis 10, wobei die Schutzbeschichtung (3) volumenmäßig mehrheitlich eine Phase γ' aufweist.

12. Teil (1) nach einem der Ansprüche 8 bis 11, wobei die Schutzbeschichtung (3) mindestens Nickel, Aluminium, Chrom, Hafnium und Silizium umfasst.

13. Teil (1) nach Anspruch 12, wobei die Schutzbeschichtung (3) aufweist:
- einen mittleren Massenmehrheitsanteil an Nickel,
- einen mittleren Massenanteil an Aluminium zwischen 5% und 15%,
- einen mittleren Massenanteil an Chrom zwischen 7% und 15%,
- einen mittleren Massenanteil an Hafnium zwischen 0,5% und 2%, und
- einen mittleren Massenanteil an Silizium zwischen 0,5% und 3%.

14. Flugzeugteil nach einem der Ansprüche 8 bis 13.

15. Flugzeugturbine, die ein Teil nach einem der Ansprüche 8 bis 14 umfasst.

16. Flugzeug, umfassend ein Teil nach einem der Ansprüche 8 bis 14.

## Claims

1. A method for manufacturing a part (1), comprising the steps of:
a) chemical attack, in a wet acid medium, of at least a portion of a surface of a substrate (2) made of a monocrystalline superalloy, comprising at least one element chosen from rhenium and ruthenium, the substrate (2) having a γ-γ' phase, the substrate (2) having an average mass fraction of rhenium and/or ruthenium greater than or equal to 3%, preferably greater than or equal to 4%, the chemical attack being carried out in such a way that the average mass fraction of rhenium and/or ruthenium over the portion of the surface of the substrate (2) is less than 2%,
b) depositing on the portion of the substrate (2) a protective coating (3) having a γ-γ' phase and an average mass fraction of rhenium and/or ruthenium of less than 1%.

2. The method according to claim 1 wherein the substrate (2) is made of nickel-based monocrystalline superalloy.

3. The method according to claim 1 or 2, wherein the substrate (2) comprises chromium, the average mass fraction of chromium being less than 5% and preferably less than 3%.

4. The method according to one of claims 1 to 3, wherein the chemical attack is a chemical etching.

5. The method according to one of claims 1 to 4, wherein the chemical attack is carried out so that the portion of the surface of the substrate (2) has an arithmetic average roughness Rₐ between 0.5 µm and 5 µm and preferably a maximum roughness R_{z} between 5.5 µm and 50 µm, the roughnesses Rₐ and R_{z} being measured over areas greater than 1 mm².

6. The method according to one of claims 1 to 5, wherein the chemical attack in acid medium is carried out by a bath in contact with the portion of the surface of the substrate (2), the bath comprising at least one element from hydrofluoric acid, nitric acid with ferric chloride and with hydrochloric acid, hydrochloric acid with ferric chloride, hydrochloric acid with hydrogen peroxide, and nitric acid with hydrochloric acid.

7. The method according to one of claims 1 to 6, wherein the chemical attack in acid medium is carried out by a bath in contact with the portion of the surface of the substrate (2), an electrical potential of the bath being controlled so as to cause an electrochemical reaction on the portion of the surface, the bath preferably comprising at least one element from nitric acid and acetic acid, sulfuric acid, and phosphoric acid.

8. A part (1), comprising:
- a substrate (2) made of a monocrystalline superalloy, comprising at least one element chosen from rhenium and ruthenium, the substrate (2) having a γ-γ' phase, an average mass fraction of rhenium and/or ruthenium greater than or equal to 3%, preferably greater than or equal to 4%,
- a protective coating (3) covering at least a portion of a surface of the substrate (2), **characterised in that**
- the average mass fraction of rhenium and/or ruthenium on the portion of the surface of the substrate (2) is less than 2%, and
- the protective coating (3) has a γ-γ' phase and an average mass fraction of rhenium and/or ruthenium of less than 1%.

9. The part (1) according to claim 8, wherein the substrate (2) comprises chromium, the average mass fraction of chromium being less than 5% and preferably less than 3%.

10. The part (1) according to claim 8 or 9, wherein the portion of the surface of the substrate (2) has an arithmetic average roughness Rₐ between 0.5 µm and 5 µm and preferably a maximum roughness R_{z} between 5.5 µm and 50 µm, the roughnesses Rₐ and R_{z} being measured over areas greater than 1 mm² and being obtained by chemical attack in a wet acid medium of the portion of the surface of the substrate (2).

11. The part (1) according to one of claims 8 to 10, wherein the protective coating (3) has predominantly by volume a γ' phase.

12. The part (1) according to one of claims 8 to 11, wherein the protective coating (3) comprises at least nickel, aluminium, chromium, hafnium and silicon.

13. The part (1) according to claim 12, wherein the protective coating (3) has:
- a majority average mass fraction of nickel,
- an average mass fraction of aluminium between 5% and 15%,
- an average mass fraction of chromium between 7% and 15%,
- an average mass fraction of hafnium between 0.5% and 2%,
and
- an average mass fraction of silicon between 0.5% and 3%.

14. An aircraft part according to one of claims 8 to 13.

15. An aircraft turbine comprising a part according to one of claims 8 to 14.

16. An aircraft comprising a part according to one of claims 8 to 14.
